# EUROPÄISCHE PATENTANMELDUNG

(11) **EP 2 141 970 A1**
(43) Veröffentlichungstag der Anmeldung: **06.01.2010**
(21) Anmeldenummer: 08011765.8
(22) Anmeldetag: 30.06.2008
(51) Int. Cl.: H05K 1/02, G05B 19/12

(54) **Leiterplatte mit einem RFID-Chip für die Rückverfolgbarkeit und Verfahren zum Herstellen einer solchen Leiterplatte**

(71) Anmelder: Elfab AG Eletronikfabrikation, 5507 Mellingen (CH)
(72) Erfinder: Hüsler, Stephan, 5600 Lenzburg (CH); Roth, Oliver, 5443 Niederrohrdorf (CH)
(74) Vertreter: Schalch, Rainer

(57) **Zusammenfassung**

Die Erfindung betrifft eine Leiterplatte mit wenigstens einem RFID-Chip (3), wobei die Leiterplatte (1) eine Vertiefung (2) aufweist und der wenigstens eine RFID-Chip (3) derart in der Vertiefung (2) eingebracht ist, dass er nicht über die Leiterplatte (1) herausragt. Die Erfindung betrifft ferner ein Verfahren zum Herstellen einer solchen Leiterplatte (1), bei dem die Leiterplatte (1) mit einer Vertiefung (2) versehen wird, ein RFID-Chips (3) in die Vertiefung (2) eingebracht wird, der RFID-Chip (3) mit wenigstens einer Leiterbahn der Leiterplatte (1) verbunden wird und die den eingebrachten RFID-Chip (3) enthaltende Vertiefung (2) versiegelt wird.

## Beschreibung

Die Erfindung betrifft eine Leiterplatte gemäss Oberbegriff des Anspruchs 1 und ein Verfahren zum Herstellen einer solchen Leiterplatte gemäss Oberbegriff des Anspruchs 5.

Unter einer Leiterplatte im Sinne der Erfindung wird eine Leiterplatte verstanden, die einen Träger aus elektrisch isolierendem Material aufweist, der mit elektrisch leitenden Verbindungen in Form von Leiterbahnen versehen ist, wobei unter einer Leiterplatte ebenfalls eine Leiterkarte, eine Platine oder ein PCB (Printed Circuit Board) verstanden werden. Die Erfindung findet beispielsweise Anwendung in Bereichen, in denen Halbleiter, elektrisch leitende Verbindungen, Leiterplatten jedweder Art sowie Produkte auf FR4- (flame retardant 4 - flammenhemmend 4) und/oder Polytetrafluorethylen-(bzw. Teflon-)Basis, aus Hartkarton, Hartpapier eingesetzt werden, wobei diese Produkte - mit Ausnahme von FR4 - bevorzugt nicht aus Polymeren oder Polyethylenen bestehen. Unter dem Material FR4 wird ein Glasfasergewebe mit Epoxidharz verstanden.

Aus der Patentanmeldung US-A1-2007/0198113 A1 ist ein RFID-Tag (Radio Frequency Identification-Tag) für eine Baueinheit mit einem RFID-Chip und einer Antenne bekannt. Auf dem RFID-Chip ist eine Darstellung der Fertigungsgeschichte der Baueinheit dadurch hinterlegt, dass Daten produktionsrelevanter Ereignisse auf dem RFID-Chip abgespeichert worden sind, die eine Lieferantenidentifikationsnummer, eine Teilenummer, eine Seriennummer und Daten von Unterbaugruppen umfassen können. Auf dem RFID-Chip werden Daten für anfängliche Fertigungsereignisse und Daten für spätere Fertigungsereignisse gespeichert.

Es ist Aufgabe der vorliegenden Erfindung, eine Leiterplatte und ein Verfahren zu deren Herstellung bereitzustellen, wobei anhand der Leiterplatte selbst der Fertigungsprozess der Leiterplatte, der mehrere Fertigungsteilprozesse umfassen kann, rückverfolgt werden kann, ohne dass extern auf die Leiterplatte eine zusätzliche Komponente wie beispielsweise ein Klebeetikett aufgebracht werden muss. Ein Fertigungsteilprozess wird im Folgenden auch als Fertigungsstufe bezeichnet.

Die Aufgabe wird durch eine Leiterplatte mit den Merkmalen des Anspruchs 1 und durch ein Verfahren zum Herstellen einer Leiterplatte mit den Merkmalen des Anspruchs 5 gelöst.

Die erfindungsgemässe Leiterplatte weist wenigstens einen RFID-Chip und eine Vertiefung auf, wobei der wenigstens eine RFID-Chip derart in die Vertiefung eingebracht ist, dass er nicht über die Leiterplatte hinausragt. Das heisst, der RFID-Chip ist in die Leiterplatte vollständig integriert bzw. implantiert und zwar vorzugsweise derart, dass er von aussen nicht mechanisch zugänglich ist, wobei die den RFID-Chip (3) enthaltende Vertiefung (2) bevorzugt mittels einer Schutzschicht versiegelt ist. Eine optische Zugänglichkeit ist nur bei transparentem Material der Leiterplatte gegeben.

Gemäss dem erfindungsgemässen Verfahren wird eine Leiterplatte mit einer Vertiefung versehen, ein RFID-Chip in die Vertiefung eingebracht, der RFID-Chip mit wenigstens einer Leiterbahn der Leiterplatte verbunden und die Vertiefung versiegelt, sodass der RFID-Chip mit einer Abdeckung versehen und somit vollständig in die Leiterplatte integriert bzw. implantiert wird. Die Abmessungen, insbesondere der Durchmesser, der Vertiefung werden bei dem erfindungsgemässen Verfahren bevorzugt in Abhängigkeit von den Abmessungen des einzubringenden RFID-Chips gewählt und zwar derart, dass die Abmessungen der Vertiefung in der Ebene, in welche sich die Leiterplatte erstreckt, im Wesentlichen den Abmessungen des RFID-Chips in eben dieser Ebene entsprechen.

Das vollständige Einbringen des RFID-Chips in die Leiterplatte hat den Vorteil, dass kein zusätzlicher Aufwand und Platzbedarf dahingehend entsteht, dass aussen an die Leiterplatte eine zusätzliche Komponente zur Identifikation wie beispielsweise ein Klebeetikett, ein aufgelöteter IC (Integrated Circuit), ein Barcode oder ein so genannter Breakway Tab bzw. Breakaway Tab angebracht werden muss.

Vorteilhafterweise sind bzw. werden produkt- und/oder produktionsrelevante Daten auf den RFID-Chip geschrieben und zwar insbesondere zum Zwecke der Rückverfolgbarkeit, der Datensicherung und/oder der Qualitätssicherung. Durchläuft die Leiterplatte mehrere Fertigungsstufen, so können während dem Durchlaufen jeder der Fertigungsstufen der jeweiligen Fertigungsstufe zugeordnete Daten auf den RFID-Chip geschrieben werden. Die produkt- und/oder produktionsrelevanten Daten werden bevorzugt jeweils am Ort ihres Entstehens auf den RFID-Chip geschrieben und zwar insbesondere unabhängig von der jeweiligen Fertigungsmaschine. Ferner können sie unabhängig von den für die jeweilige Fertigungsstufe verwendeten Fertigungsparametern sein.

Mit Hilfe der auf dem RFID-Chip gespeicherten Daten können der Fertigungsprozess und die gegebenenfalls durchlaufenen Teilprozesse/Fertigungsstufen des Fertigungsprozesses rückverfolgt und eine Qualitätssicherung erreicht werden. Durch das Schreiben der Daten auf den RFID-Chip wird weiter eine Sicherung der Daten erreicht. Produkt- und/oder produktionsrelevante Daten werden vorteilhafterweise direkt mit dem hergestellten Produkt, nämlich der Leiterplatte, verknüpft und müssen daher nicht beim Hersteller abgefragt werden. Es ergibt sich somit eine fertigungsprozessübergreifende, vom Hersteller unabhängige Rückverfolgbarkeit (Traceability) in Bezug auf den Fertigungsprozess und dessen Teilprozesse/ Fertigungsstufen, wobei sich die Herstellerunabhängigkeit auch auf den Hersteller der Fertigungsmaschinen erstreckt. Das Schreiben der Daten auf den RFID-Chip und das Editieren der Daten bleiben vorzugsweise dem Hersteller und gegebenenfalls den Lieferanten/Zwischenhändlern überlassen.

Weitere vorteilhafte Ausgestaltungen der Erfindung ergeben sich aus den abhängigen Ansprüchen und den anhand der Zeichnungen nachfolgend dargestellten Ausführungsbeispielen. Es zeigen:
Fig. 1 eine schematische, perspektivische Darstellung einer erfindungsgemässen Leiterplatte und
Fig. 2 ein Flussdiagramm des erfindungsgemässen Verfahrens.

In den Figuren bezeichnen gleiche Bezugszeichen strukturell- bzw. funktionell gleiche bzw. gleich wirkende Komponenten.

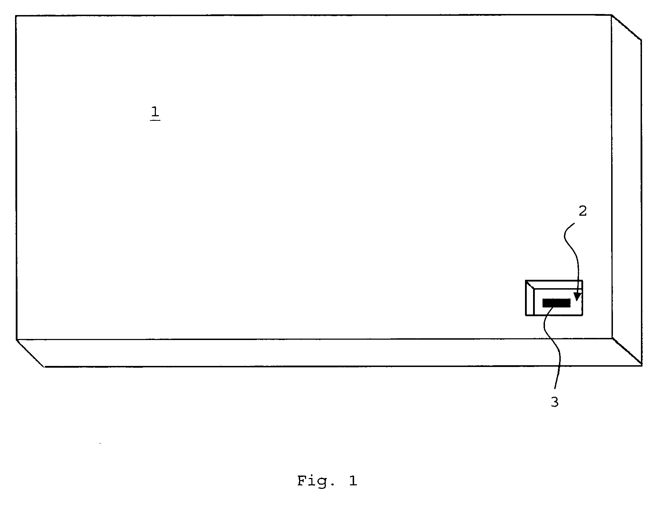

Figur 1 zeigt eine erfindungsgemässe Leiterplatte 1, die eine Vertiefung 2 aufweist, in die eine RFID-Chip 3 als RFID-Implantat eingebracht ist, wobei der RFID-Chip 3 nicht über die Leiterplatte 1 hinausragt. Bei der Vertiefung 2 kann es sich zum Beispiel um eine Ausfräsung oder eine Aussparung handeln. Die Vertiefung 2 ist mit einer nicht dargestellten Versiegelung versehen, die den RFID-Chip 3 abdeckt und die Vertiefung 2 verschliesst. Der RFID-Chip 3 kann jegliche Form und Aufbauart aufweisen, wobei es sich beispielsweise um einen Wafer und/oder einen RFID-Chip mit einer substrahierten, polierten, gesägten, gebondeten und/oder ähnlichen Aufbauart handeln kann.

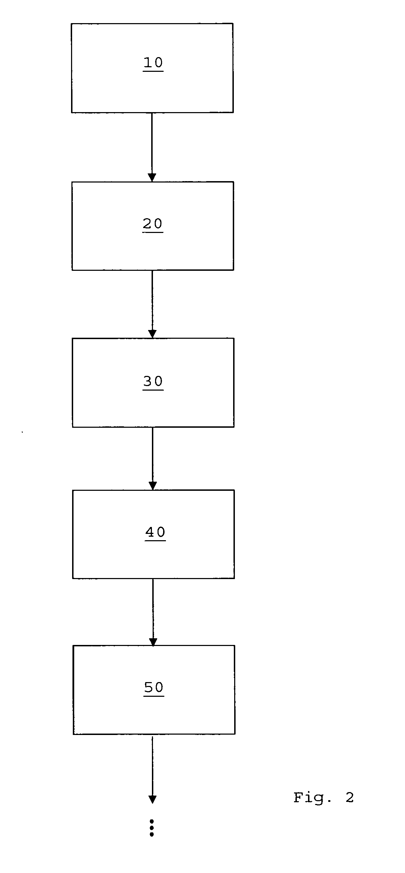

Figur 2 stellt ein Flussdiagramm des erfindungsgemässen Verfahrens zur Herstellung der in Figur 1 gezeigten Leiterplatte dar. In Verfahrensschritt 10 wird die Leiterplatte an geeigneter Stelle mit einer Vertiefung versehen, wobei der Durchmesser der Vertiefung gemäss den Abmessungen des in die Vertiefung einzubringenden RFID-Chips gewählt wird. Die Leiterplatte kann beispielsweise durch mechanische Bearbeitung wie Fräsen oder durch Aussparen von Material mit einer Vertiefung versehen werden, wobei das Versehen mit einer Vertiefung je nach Grösse des RFID-Chips, Form des RFID-Chips und/oder der Materialstärke während, vor oder nach einer Fertigungsstufe am Trägermaterial (z.B. FR4) der Leiterplatte ausgeführt werden kann.

Die Leiterplatte weist typischerweise elektrisch leitende Verbindungen in Form von Leiterbahnen auf, von denen nach dem Versehen mit einer Vertiefung zumindest eine an einer Seitenwand der Vertiefung frei geworden und sichtbar ist. Die Leiterbahn kann beispielsweise durch eine innenliegende Kupferschicht (copper layer)/einen innenliegenden Kupferleiter gebildet sein. Die Stelle an der die Vertiefung zur Aufnahme eines RFID-Chips in die Leiterplatte eingebracht wird, wird insbesondere anhand der Herstellungsdaten der verwendeten Leiterplatte festgelegt.

In Verfahrensschritt 20 wird mit einer geeigneten Maschine oder manuell ein RFID-Chip in die Vertiefung eingebracht, wobei das Versehen der Leiterplatte mit einer Vertiefung (Verfahrensschritt 10) und/oder die Einbringung des RFID-Chips (Verfahrensschritt 20) in die Leiterplatte an einem beliebigen Zeitpunkt in der Fertigungsprozesskette der Leiterplatte erfolgen können. Es können auch mehrere RFID-Chips in eine Vertiefung eingebracht werden. Selbstverständlich kann die Leiterplatte in Verfahrensschritt 10 auch mit mehreren Vertiefungen versehen werden, wobei in jede Vertiefung in Verfahrensschritt 20 ein oder mehrere RFID-Chips eingebracht werden können.

In Verfahrensschritt 30 werden Kontaktflächen des RFID-Chips mit einer Leiterbahn verbunden, die beim Durchführen von Verfahrensschritt 10 freigelegt worden ist. Die Verbindung von Leiterbahn und Kontaktflächen kann beispielsweise dadurch erfolgen, dass mittels eines Lasers die Kontaktflächen mit der Leiterbahn zusammengeschweisst werden. Die Verbindung von Kontaktflächen und Leiterbahn kann alternativ oder zusätzlich beispielsweise auch durch Wärmezufuhr, elektrisch leitenden Kleber, Pressen, Thermopressen, heiss- und/oder kaltschmelzende Verfahren, Drucken, Löten, Schweissen, Bonden, eine Kombination hiervon oder auf ähnliche Weise erfolgen. Selbstverständlich können die Kontaktflächen des RFID-Chips entsprechend auch mit mehreren beim Durchführen des Verfahrensschritts 10 freigelegten Leiterbahnen verbunden werden. Je nach Leiterplatte kann das Material der Leiterbahnen variieren. Gängige Metallisierungen und/oder Legierungen können eingesetzt werden wie beispielsweise Kupfer, Silber, Gold, gegebenenfalls mit OSP (organic surface protection - organischer Oberflächenschutz).

Die bereits in der Leiterplatte vorhanden gewesene Leiterbahn, mit der der RFID-Chip im Verfahrensschritt 30 verbunden worden ist, bildet die Antenne (bzw. den Funkübertrager) des RFID-Chips zum Empfangen/Senden eines RFID-Signals, sodass eine zusätzliche Antenne vorteilhafterweise nicht auf die Leiterplatte aufgebracht werden muss. Die jeweilige Leiterbahn kann hierbei die Funktion als Antenne zusätzlich zu der ihr innerhalb der Leiterplatte zugedachten Funktion oder als alleinige Funktion übernehmen. Die Antenne kann auch durch mehrere Leiterbahnen - beispielsweise mehrere Schichten (layers) - gebildet sein, mit denen die Kontaktflächen des RFID-Chips im Verfahrensschritt 30 verbunden worden sind. Die Nutzung einer oder mehrerer Leiterbahnen, wobei auch eine Schicht als Leiterbahn verstanden wird, als Antenne erfolgt bevorzugterweise ohne Beeinträchtigung der Wirkungsweise der auf der Leiterplatte am Ende des Fertigungsprozesses implementierten elektrischen Schaltung.

In Verfahrensschritt 40 wird die Vertiefung versiegelt und dabei der eingebrachte RFID-Chip mit einer versiegelnden Schutzschicht versehen. Die Versiegelung kann beispielsweise mittels Vergiessen oder einem ähnliches, zur Abdeckung geeigneten Verfahren erfolgen, wobei das Versiegelungsverfahren insbesondere von der Anwendung des Endprodukts, d.h. der fertig gestellten Leiterplatte abhängig ist. Als Versiegelungsverfahren und als Materialien für die versiegelnde Schutzschicht können beispielsweise solche Verfahren und Materialen eingesetzt werden, die einen thermischen, mechanischen und/oder chemischen Schutz bewirken. Beim Material der versiegelnden Schutzschicht kann es sich beispielsweise um einen Zweikomponentenlack handeln.

Der RFID-Chip ist nach Verfahrensschritt 40 nicht mehr von aussen über mechanische Eingriffe ohne Beeinträchtigung der versiegelnden Schutzschicht zugänglich und verbleibt vorzugsweise während der gesamten Lebensdauer der Leiterplatte in diese integriert/implementiert, wobei der RFID-Chip grundsätzlich beispielsweise zu Zwecken der Archivierung, Fertigungsprozessverfolgung und/oder Qualitätssicherung unter Öffnung der versiegelnden Schutzschicht wieder aus der Leiterplatte entfernt werden kann.

In Verfahrensschritt 50 werden dann im Rahmen einer ersten Fertigungsstufe produkt- und/oder produktionsrelevante Daten (insbesondere so genannte Eck- bzw. Stammdaten) auf den RFID-Chip geschrieben, bei denen es sich beispielsweise um die Seriennummer handeln kann. Unter den produkt- und/oder produktionsrelevanten Daten werden auch Umgebungsvariablen wie zum Beispiel Temperaturen, mechanische Belastungen, Feuchtigkeit und Ähnliches verstanden. Ebenfalls können die produkt- und/oder produktionsrelevanten Daten Identifikationsdaten umfassen, die während jeder Fertigungsstufe bzw. während jedem Fertigungsschritt einer Kundenspezifikation angepasst werden können. Weiter unten sind beispielhaft weitere produkt- und/oder produktionsrelevante Daten angegeben.

Jede sich an die erste Fertigungsstufe anschliessende weitere Fertigungsstufe des Fertigungsprozesses schreibt vorzugsweise die ihr zugeordneten produkt- und/oder produktionsrelevanten Daten auf den RFID-Chip. Dies ist in Figur 2 durch den sich an den Block 50 anschliessenden Pfeil und den Dreipunkt angedeutet. Im Rahmen der letzten und abschliessenden Fertigungsstufe können die produkt- und/oder produktionsrelevanten Daten dann archiviert werden. Somit kann der RFID-Chip während des gesamten Fertigungsprozesses - vorzugsweise zu jeder beliebigen Zeit - beschrieben und bevorzugt auch ausgelesen werden, wobei sowohl das Beschreiben als auch das Auslesen verschlüsselt erfolgen können. Auch während oder nach einer Anwendung der fertig gestellten Leiterplatte (z.B. bei Service-Einsätzen), d.h. nachdem die Leiterplatte den gesamten Fertigungsprozess durchlaufen hat und bereits als fertig gestelltes Produkt eingesetzt wird bzw. worden ist, können die auf dem RFID-Chip gespeicherten Daten verschlüsselt oder unverschlüsselt ausgelesen werden, wobei unterschiedliche Benutzungsrechte definiert werden können, die je nach Benutzungsrecht einen unterschiedlichen Zugriff auf die gespeicherten Daten, insbesondere einen Zugriff auf unterschiedliche gespeicherte Daten (z.B. Daten unterschiedlicher Sicherheitsklassen), erlauben. So können zum Beispiel bei Service-Einsätzen die auf dem RFID-Chip hinterlegten Daten ausgelesen und vorzugsweise zumindest auch teilweise wieder neu in dem RFID-Chip abgelegt werden, z.B. die Software-Versionsnummer beim Flashen von neuer Software.

Das Versehen der Leiterplatte mit dem RFID-Chip und das Schreiben produkt- und/oder produktionsrelevanter Daten dienen insbesondere dem Zwecke der Fehleranalyse, der Rückverfolgbarkeit, der Fertigungsprozesskontrolle, der Datenarchivierung und/oder der Produktverfolgung, wobei diese Aufzählung nicht abschliessend ist.

Die produkt- und/oder produktionsrelevanten Daten können beispielhaft die folgenden Daten umfassen: Leiterplatten-Herstelldaten (z.B. Charge etc.), Seriennummer, für das Siebdrucken charakteristische Daten (z.B. Paste, Charge, Datum und Uhrzeit des Druckens), für das SMD-Bestücken (Surface Mounted Device-Bestücken) charakteristische Daten (z.B. Datum und Uhrzeit des Bestückens, Bauteiltypen, Bauteilhersteller, Bauteilchargennummer, SMD-Bestückungsprogramm, SMD-Maschine, Seite der Leiterplatte, auf welcher bestückt worden ist), für das Reflowlöten charakteristische Daten (z.B. Datum und Uhrzeit des Reflowlötens, Lötprogramm, Lötofen, Seite der Leiterplatte, auf welcher gelötet worden ist, Löttemperaturen, Häufigkeit des Erhitzens beim Löten), für die AOI (automatische optische Inspektion) und/oder das Röntgen charakterische Daten (z.B. Datum und Uhrzeit der AOI/des Röntgens, Anzahl gemeldeter Fehler), für die Reparatur nach einer AOI charakteristische Daten (z.B. Reparaturdaten wie Uhrzeit, Datum und repariertes Bauteil, die Person, die die Reparatur durchgeführt hat), für das Löten mittels einer SLA (Selektiv-Lötanlage) charakteristische Daten (z.B. Datum und Uhrzeit des Lötens, Lötprogramm, Löttemperaturen, Häufigkeit des Erhitzens beim Löten), für das Testen, die Anwendung einer so genannten Flying Probe und/oder einen Endgerätetest charakteristische Daten (z.B. Datum und Uhrzeit des durchgeführten Tests, Flash-Informationen, Stücklisten-Versionsnummer, Fehler-Historie) und für die Endgerätemontage charakteristische Daten (z.B. Datum und Uhrzeit der Montage, die Person, die die Montage durchgeführt hat). Ferner können die produktrelevanten Daten Produktbezeichnung, Seriennummer, Hardware-Stand-Nummer, Software-Stand-Nummer (z.B. Software, Firmware, ob das Bios eingeschlossen ist), Freigabe-Nummer vom Entwickler, Zertifikationsnummer (z.B. gemäss ATEX-(Atmosphère explosible-)Produktrichtlinie, CE-(Communauté Européenne-)Kennzeichnung), Stücklisten-Nummer inklusive Hersteller und Charge und das Ablaufdatum der Gewährleistung umfassen. Weiterhin können als produkt- und/oder produktionsrelevante Daten bei einer Anwendung der Leiterplatte in Verbindung mit MEMS-(Micro-Electro-Mechanical-System-)Bauteilen je nach technischer Ausprägung zum Beispiel Vibrations-/Schockwerte, Einsatztemperaturen und die Energieversorgung der MEMS-Bausteine gespeichert werden.

Die Grösse des für die Speicherung der produkt- und/oder produktionsrelevanten Daten auf dem RFID-Chip vorgesehen Speichers ist je nach Anwendung variabel, wobei zum Schreiben von Daten in den Speicher und zum Auslesen von Daten aus dem Speicher entsprechende Read-(Lese-), Write-(Schreib-) oder Read-Write-(Lese-Schreib-)Module vorzusehen sind. Die produkt- und/oder produktionsrelevanten Daten können klassifiziert und je nach Klassifikation in unterschiedlichen Partitionen des Speichers abgespeichert werden, wobei die Klassifikation zum Beispiel nach Daten nur den Hersteller betreffend, Daten Hersteller und OEM (Original Equipment Manufacturer-Orignalgerätehersteller) betreffend, nur den OEM betreffend erfolgen kann. Für die verschiedenen Partitionen kann es unterschiedliche Schreib-/Leserechte geben. Die Datenspeicherung bzw. -ablage kann verschlüsselt und unverschlüsselt erfolgen, sodass auch Daten für sicherheitsrelevante Einsatzgebiete (z.B. militärische Anwendungen, medizinische Anwendungen) in verschlüsselter Form hinterlegt werden können.

## Patentansprüche

1. Leiterplatte mit wenigstens einem RFID-Chip (3), **dadurch gekennzeichnet, dass** die Leiterplatte (1) eine Vertiefung (2) aufweist und dass der wenigstens eine RFID-Chip (3) derart in der Vertiefung (2) eingebracht ist, dass er nicht über die Leiterplatte (1) herausragt.

2. Leiterplatte nach Anspruch 1, **dadurch gekennzeichnet, dass** eine Antenne für den RFID-Chip (3) durch eine oder mehrere Leiterbahnen der Leiterplatte (1) gebildet ist.

3. Leiterplatte nach Anspruch 1 oder 2, **dadurch gekennzeichnet, dass** auf den RFID-Chip (3) produkt- und/oder produktionsrelevante Daten geschrieben sind.

4. Leiterplatte nach einem der vorhergehenden Ansprüche, **dadurch gekennzeichnet, dass** die den RFID-Chip (3) enthaltende Vertiefung (2) mittels einer Schutzschicht versiegelt ist.

5. Verfahren zum Herstellen einer Leiterplatte (1) nach einem der vorhergehenden Ansprüche, **gekennzeichnet durch** die folgenden Schritte:
- Versehen der Leiterplatte (1) mit einer Vertiefung (2),
- Einbringen eines RFID-Chips (3) in die Vertiefung (2),
- Verbinden des RFID-Chips (3) mit wenigstens einer Leiterbahn der Leiterplatte (1) und
- Versiegeln der den eingebrachten RFID-Chip (3) enthaltenden Vertiefung (2).

6. Verfahren nach Anspruch 5, **dadurch gekennzeichnet, dass** die Abmessungen der Vertiefung (2) in Abhängigkeit von den Abmessungen des RFID-Chips (3) gewählt werden.

7. Verfahren nach Anspruch 5 oder 6, **dadurch gekennzeichnet, dass** produkt- und/oder produktionsrelevante Daten auf den RFID-Chip (3) geschrieben werden.

8. Verfahren nach Anspruch 7, **dadurch gekennzeichnet, dass** die produkt- und/oder produktionsrelevanten Daten für die Rückverfolgbarkeit, die Datensicherung und/oder die Qualitätssicherung auf den RFID-Chip (3) geschrieben werden.

9. Verfahren nach Anspruch 7 oder 8, **dadurch gekennzeichnet, dass** für den Fall, dass die Leiterplatte (1) mehrere Fertigungsstufen durchläuft, während dem Durchlaufen zumindest einiger der mehreren Fertigungsstufen zu der jeweiligen Fertigungsstufe zugeordnete Daten auf den RFID-Chip (3) geschrieben werden.

10. Verfahren nach einem der Ansprüche 7 bis 9, **dadurch gekennzeichnet, dass** das Beschreiben des RFID-Chips (3) verschlüsselt oder unverschlüsselt erfolgt.

11. Verwendung eines RFID-Chips (3) zur Rückverfolgung der Fertigung einer Leiterplatte (1), insbesondere einer Leiterplatte (1) nach einem der Ansprüche 1 bis 4.
